**Europäisches Patentamt**

**European Patent Office**

**Office européen des brevets**

(19)

(11) Numéro de publication: **0 167 437**
**B1**

(12) ## FASCICULE DE BREVET EUROPEEN

(45) Date de publication du fascicule du brevet:
**28.12.88**

(51) Int. Cl.⁴: **H 01 L 21/76**

(21) Numéro de dépôt: **85401135.0**

(22) Date de dépôt: **10.06.85**

(54) Procédé d'autopositionnement d'un oxyde de champ localisé par rapport à une tranchée d'isolement.

(30) Priorité: **14.06.84 FR 8409315**

(43) Date de publication de la demande:
**08.01.86 Bulletin 86/2**

(45) Mention de la délivrance du brevet:
**28.12.88 Bulletin 88/52**

(84) Etats contractants désignés:
**BE CH DE GB IT LI NL**

(56) Documents cités:
**EP-A- 0 090 111**
**EP-A- 0 091 507**

**IBM TECHNICAL DISCLOSURE BULLETIN, vol. 24, no. 7B, décembre 1981, pages 3841-3843, New York, US; S. MAGDO: " "T" Trench recessed oxide isolation scheme"**
**IBM TECHNICAL DISCLOSURE BULLETIN, vol. 24, no. 7A, décembre 1981, pages 3389-3391, New York, US; A.P. HO et al.: "Self-aligned "framed" recessed-oxide-isolation process"**
**IBM TECHNICAL DISCLOSURE BULLETIN, vol. 20, no. 1, juin 1977, pages 144-145, New York, US; S.A. ABBAS: "Recessed oxide isolation process"**

(73) Titulaire: **COMMISSARIAT A L'ENERGIE ATOMIQUE, 31/33, rue de la Fédération, F-75015 Paris (FR)**

(72) Inventeur: **Buiguez, François, 22, rue des Bonnais, F-38120 Saint Egreve (FR)**
Inventeur: **Hartmann, Joel, 13, rue de la Balmette, F-38640 Claix (FR)**

(74) Mandataire: **Mongrédien, André et al, c/o BREVATOME 25, rue de Ponthieu, F-75008 Paris (FR)**

## Description

La présente invention a pour objet un procédé d'autopositionnement d'un oxyde de champ localisé par rapport à une tranchée d'isolement.

Ce procédé peut être utilisé dans le domaine de la micro-électronique chaque fois qu'il est nécessaire d'isoler électriquement les uns des autres les composants d'un circuit (transistors, diodes, etc...), réalisés sur un support semiconducteur. Il s'applique donc plus particulièrement aux circuits intégrés utilisant le silicium comme substrat tel que les circuits intégrés MOS, CMOS ou bipolaires.

La recherche d'une forte densité d'intégration dans ce type de circuits intégrés nécessite d'utiliser plus particulièrement pour les circuits intégrés CMOS une technique d'isolement spéciale entre les différents composants de ces circuits et notamment entre les transistors de type N et ceux de type P, lorsque l'on veut réduire la distance entre ces transistors complémentaires.

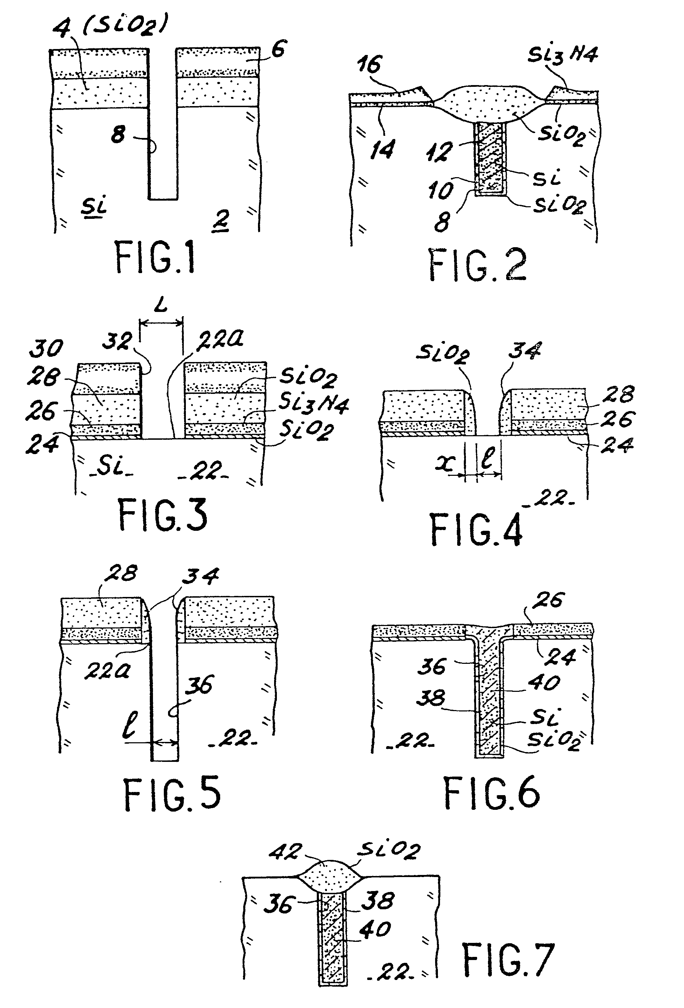

L'une des techniques récentes d'isolation utilisées dans ce but est basée sur la réalisation d'une tranchée d'isolement, dans un substrat semiconducteur, surmontée d'un oxyde de champ localisé. Sur les figures 1 et 2, on a représenté les différentes étapes d'une telle technique d'isolation.

La première étape de ce procédé, comme représenté sur la figure 1, consiste à déposer sur un substrat en silicium monocristallin 2 une couche d'oxyde de silicium 4 présentant une épaisseur de l'ordre du micron. Après réalisation d'un masque de résine 6, la couche d'oxyde 4 est gravée de façon anisotrope jusqu'à mise à nu d'une région du substrat dans laquelle sera réalisée la tranchée. L'emploi d'une gravure anisotrope permet de ne graver la couche d'oxyde 4 que suivant une seule direction de l'espace.

Après élimination du masque 6, on ouvre des tranchées 8 dans le substrat 2 en gravant le substrat sur plusieurs microns (5 μm par exemple) à l'aide d'une technique de gravure anisotrope. On procède alors à l'élimination de la couche d'oxyde 4 par voie chimique. La tranchée 8 ainsi réalisée est ensuite oxydée thermiquement afin que celle-ci présente, comme représentée sur la figure 2, des bords isolants 10 puis remplie d'un matériau 12 tel que du silicium polycristallin.

Ce remplissage se fait par dépôt du matériau 12, généralement par un procédé de dépôt chimique en phase vapeur, suivi d'un enlèvement de l'excédent de celui-ci se trouvant hors de la tranchée 8. Sur la tranchée d'isolement ainsi obtenue, on peut alors réaliser l'oxyde de champ localisé.

Pour cela, on réalise tout d'abord une oxydation thermique du substrat 2 et du matériau 12 en silicium afin d'obtenir une couche mince 14 d'oxyde de silicium, de 20 à 50 μm d'épaisseur, puis on dépose une couche de nitrure de silicium 16, notamment par un procédé de dépôt chimique en phase vapeur. Ensuite, après positionnement par rapport à la tranchée d'isolement 8 d'un masque (non représenté) sur la couche de nitrure 16, on réalise une gravure chimique, par voie sèche ou humide, de la couche de nitrure. On procède alors à une oxydation thermique épaisse, localisée dans les régions où la couche de nitrure 16 a été gravée. La technique consistant à réaliser un oxyde de champ par oxydation localisée à partir de motifs généralement en nitrure de silicium, est connue sous le nom de technologie LOCOS.

Après réalisation de l'oxyde de champ, on élimine la couche de nitrure 16, par exemple par voie chimique.

Ce procédé permet d'obtenir une bonne isolation en profondeur ainsi qu'une bonne isolation en surface entre notamment les transistors MOS de type N et ceux de type P des circuits CMOS. En revanche, ce procédé limite la densité d'intégration des circuits intégrés utilisant cette technique d'isolement; cette limitation est principalement due au fait que l'oxyde de champ localisé n'est nullement autopositionnée ou autoaligné par rapport à la tranchée d'isolement correspondante.

La présente invention a précisément pour objet un procédé permettant d'autopositionner un oxyde de champ localisé par rapport à une tranchée d'isolement et donc d'augmenter la densité d'intégration des circuits intégrés utilisant un tel procédé.

De façon plus précise, l'invention a pour objet un procédé d'autopositionnement d'un oxyde de champ localisé par rapport à une tranchée d'isolement dans un substrat en silicium, caractérisé en ce qu'il comprend les étapes successives suivantes:

(a) réalisation d'au moins une première couche de matériau isolant sur la surface du substrat,
(b) réalisation d'une deuxième couche de matériau isolant sur ladite première couche,
(c) réalisation d'une gravure anisotrope des première et deuxième couches de matériau isolant jusqu'à la mise à nu de la région du substrat dans laquelle sera réalisée la tranchée,
(d) réalisation d'espaceurs isolants sur les flancs gravés des première et deuxième couches de matériau isolant.
(e) réalisation d'une gravure anisotrope de ladite région du substrat afin de réaliser la tranchée, la deuxième couche de matériau isolant gravée et les espaceurs servant de masque à cette gravure,
(f) élimination de la deuxième couche de matériau isolant gravée et des espaceurs,
(g) réalisation de bords isolants dans la tranchée,
(h) remplissage de la tranchée par un matériau de remplissage, et
(i) réalisation de l'oxyde de champ localisé.

Dans ce procédé, la réalisation des espaceurs isolants permet de définir la dimension réelle de la tranchée à réaliser. Il contribue fortement à obtenir un autopositionnement de l'oxyde de champ localisé par rapport à la tranchée d'isolement.

De façon avantageuse, on réalise, entre les étapes (b) et (c), un masque de résine sur la deuxième couche de matériau isolant afin de définir exactement l'emplacement de la tranchée.

Ce masque de résine présente la propriété d'avoir une ouverture dont la largeur est plus grande que celle de la tranchée à réaliser.

La réalisation d'un tel masque permet de favoriser l'autopositionnement de l'oxyde de champ localisé par rapport à la tranchée d'isolement.

Le procédé d'autopositionnement de l'invention peut avantageusement être utilisé pour un oxyde de champ complètement enterré. Pour un tel oxyde de champ, on peut, selon l'invention, réaliser soit, une légère gravure anisotrope de la région du substrat mise à nu, entre les étapes (c) et (d) à travers le masque de résine, soit, une légère gravure isotrope de cette même région du substrat, entre les étapes (d) et (e), la deuxième couche de matériau isolant gravée et les espaceurs servant de masque à cette gravure.

Par ailleurs, le matériau de remplissage peut ête raboté à la surface de la tranchée, par une technique de gravure sèche associée ou non à une technique dite de «planarisation», de manière à ne laisser du matériau de remplissage qu'à l'intérieur de la tranchée.

Selon un mode préféré de mise en œuvre du procédé de l'invention, les espaceurs isolants sont réalisés en déposant une troisième couche de matériau isolant, notamment en oxyde de silicium, sur la deuxième couche de matériau isolant gravée, réalisée par exemple en oxyde de silicium, puis en gravant ladite troisième couche de façon anisotrope.

Selon un autre mode préféré de mise en œuvre du procédé de l'invention, on réalise une couche d'oxyde de silicium sur la surface du substrat, par exemple par oxydation thermique dudit substrat, puis une couche de nitrure de silicium sur ladite couche d'oxyde, par exemple par dépôt.

Selon un autre mode préféré de mise en œuvre du procédé de l'invention, le matériau servant au remplissage de la tranchée est réalisé en silicium polycristallin. Dans ce mode de réalisation, l'oxyde de champ peut être avantageusement obtenu par oxydation thermique de ce silicium polycristallin.

D'autres caractéristiques et avantages de l'invention ressortiront mieux de la description qui va suivre donnée à titre explicatif et non limitatif, en référence aux figures annexées, dans lesquelles:
- les figures 1 et 2, déjà décrites, représentent schématiquement, en coupe longitudinale, les différentes étapes d'un procédé de réalisation d'un oxyde de champ sur une tranchée d'isolement, selon l'art antérieur.
- les figures 3 à 7 représentent schématiquement, en coupe longitudinale, les différentes étapes du procédé de l'invention, selon une première variante de mise en œuvre,
- les figures 8 à 11 représentent schématiquement, en coupe longitudinale, les différentes étapes du procédé de l'invention, selon une seconde variante de mise en œuvre, et

- les figures 12 et 13 représentent schématiquement, en coupe longitudinale, les différentes étapes du procédé de l'invention, selon une troisième variante de mise en œuvre.

En se référant à la figure 3, la première étape du procédé selon l'invention consiste à réaliser sur un substrat en silicium monocristallin 22 une couche de matériau isolant 24 de préférence en oxyde de silicium ($SiO_2$). Cette couche 24 peut notamment être obtenue par oxydation thermique du substrat en silicium 22 à une température de 900°C. Cette couche 24 présente une épaisseur variant entre 10 et 50 μm.

Sur cette couche mince d'oxyde de silicium 24, on réalise une autre couche d'isolant 26, de préférence en nitrure de silicium ($Si_3N_4$). Cette couche de nitrure de silicium 26, présentant une épaisseur d'environ 80 μm peut être obtenue par dépôt par exemple du type dépôt chimique en phase vapeur (CVD ou LPCVD). Cette couche de nitrure 26 va servir à la localisation de l'oxyde de champ à réaliser.

Sur la couche 26, on réalise ensuite une autre couche d'isolant 28, de préférence en oxyde de silicium. Cette couche d'oxyde 28 qui présente une épaisseur d'environ 1 μm peut être obtenue par dépôt, notamment par un dépôt chimique en phase vapeur (CVD ou LPCVD); cette couche d'isolant gravée servira de masque lors de la gravure de la tranchée.

On réalise ensuite, comme représenté sur la figure 3, une gravure anisotrope des couches isolantes 24, 26 et 28, c'est-à-dire suivant une seule direction de l'espace, jusqu'à la mise à nu de la région 22a du substrat dans laquelle sera réalisée, ultérieurement, la tranchée d'isolement. Cette gravure peut être réalisée en utilisant un masque de résine 30 disposé sur la couche d'oxyde de silicium 28.

Ce masque 30, réalisé par les procédés classiques de la photolithographie, permet de définir l'emplacement de la tranchée d'isolement à réaliser. Il présente, avantageusement une ouverture 32 dont la largeur L est plus grande que la largeur (l de la tranchée à réaliser (figure 5). Le dimensionnement de cette ouverture 32 va permettre d'autopositionner ou d'autoaligner l'oxyde de champ localisé par rapport à la tranchée d'isolement à réaliser.

La gravure anisotrope des couches d'isolant 24, 26 et 28 peut être effectuée par une technique de gravure sèche du type ionique réactive en utilisant comme agent de gravure le trifluorométhane ($CHF_3$) lorsque ces couches sont réalisées respectivement en oxyde de silicium, en nitrure de silicium et en oxyde de silicium.

Après élimination du masque 30, par exemple par une attaque par plasma avec de l'oxygène, ou une attaque chimique avec de l'acide nitrique, on réalise, comme représenté sur la figure 4, des espaceurs isolants 34 sur les flancs gravés des couches 24, 26, et 28 isolantes. Ces espaceurs, 34, de préférence en oxyde de silicium, permettent de définir la dimension réelle, c'est-à-dire la lar-

geur l̳ de la tranchée d'isolement réalisée ultérieurement.

Ces espaceurs 34 peuvent être par exemple réalisés en déposant une couche d'oxyde de silicium sur la couche 28, ayant une épaisseur variant de 300 à 500 µm, puis en gravant cette couche d'oxyde de façon anisotrope par voie sèche, par exemple par une gravure ionique réactive avec comme agent de gravure le trifluorométhane (CHF₃). La réalisation d'une gravure anisotrope de la couche d'oxyde de silicium permet d'obtenir des espaceurs 34 dont la largeur x est définie par l'épaisseur de cette couche d'oxyde.

Cette largeur x, définissant la distance séparant les flancs de la tranchée des zones actives des composants, et notamment des drains des transistors N ou P des circuits CMOS, est déterminée de manière à éviter toute conduction parasite sur les flancs de la tranchée.

L'étape suivante du procédé, comme représenté sur la figure 5, consiste à réaliser une gravure anisotrope de la région 22a du substrat mise à nu afin de réaliser une tranchée 36, présentant une largeur l̳ de l'ordre du 1 µm et une profondeur de l'ordre de 5 µm. Cette gravure peut être réalisée par un procédé de gravure ionique réactive avec comme agent de gravure du tétrachlorure de carbone (CCL₄) ou de l'hexafluorure de soufre (SF₆). La couche d'oxyde de silicium 28 gravée et les espaceurs isolants 34 sont utilisés comme masque à cette gravure du substrat.

Comme représenté sur la figure 6, on élimine ensuite la couche d'oxyde de silicium 28 gravée et les espaceurs isolants 34, par exemple par un procédé de gravure sèche du type ionique réactive avec comme agent d'attaque du trifluorométhane (CHF₃) ou par une gravure humide avec comme agent d'attaque un mélange d'acide fluorhydrique (HF), et de fluorure d'ammonium (FNH₄). Après cela, on procède de façon classique au remplissage de la tranchée 36.

Comme représenté sur la figure 6, ce remplissage consiste tout d'abord à oxyder thermiquement le substrat 22 gravé, par exemple à une température de 1000°C. Cette oxydation permet d'obtenir un film d'oxyde 38, ayant une épaisseur d'environ 100 µm, sur tous les bords de la tranchée 36. Ensuite, on remplit la tranchée 36 par un matériau 40, de préférence en silicium polycristallin. Ce remplissage peut être réalisé par dépôt isotrope et notamment par la technique de dépôt chimique en phase vapeur (CVD) ou LPCV), de manière à remplir complètement la tranchée.

Après ce remplissage de la tranchée 36, on élimine l'excédent de matériau 40 pouvant se trouver hors de la tranchée 36 de façon à ne laisser le matériau 40 qu'à l'intérieur de la tranchée 36 (figure 6). Cette élimination peut par exemple être réalisée par une gravure sèche du type ionique réactive avec de l'hexafluorure de soufre comme agent d'attaque.

Cette élimination peut aussi être réalisée par une technique dite de «planarisation», consistant à déposer sur la couche de matériau 40 une couche de résine photosensible que l'on grave ensuite à la même vitesse que le matériau 40 de façon à aplanir la topographie au-dessus de la tranchée 36, cette gravure étant effectuée par une technique de gravure sèche du type ionique réactive avec un mélange de SF₆ et de O₂ comme agent d'attaque.

On réalise ensuite, comme représenté sur la figure 7, l'oxyde de champ localisé 42 notamment par oxydation thermique du silicium polycristallin 40 remplissant la tranchée 36, les motifs réalisés dans la couche de nitrure 26 servant à la localisation de cet oxyde de champ. L'épaisseur de cet oxyde de champ est voisine de 500 µm.

Ensuite, on peut éliminer la couche d'oxyde 24 et la couche de nitrure 26 par exemple par une gravure chimique avec de l'acide orthophosphorique (H₃PO₄) pour la couche 26 et un mélange FH/FNH₄ pour la couche 24.

Selon l'invention, l'oxyde de champ 42 du type LOCOS est autopositionné par rapport à la tranchée d'isolement 36 grâce à l'utilisation des espaceurs 34 isolants ainsi que de l'utilisation d'un masque de résine 30 présentant une ouverture 32 dont la largeur L est plus grande que celle l̳ de la tranchée 36 réalisée.

Le procédé décrit précédemment permet un autopositionnement d'un oxyde de champ localisé de type LOCOS, c'est-à-dire partiellement enterré, par rapport à la tranchée d'isolement. Mais il s'applique aussi à un oxyde de champ localisé enterré (recessed oxide en terminologie anglo-saxonne).

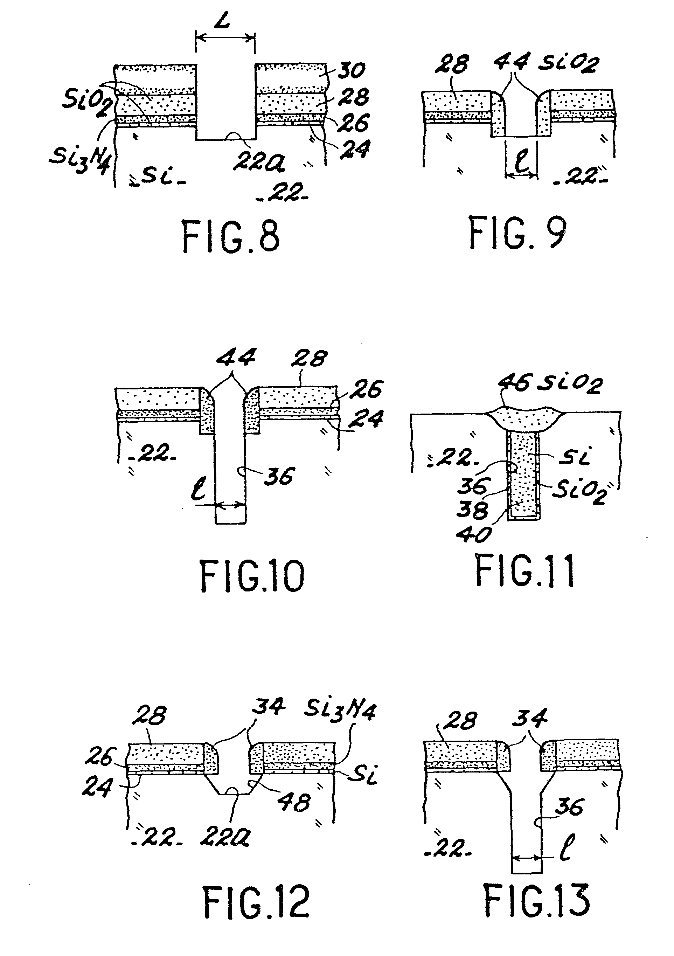

Dans une première variante, représentée sur les figures 8 à 11 on réalise, comme précédemment, l'empilement des couches isolantes 24, 26 et 28 puis la gravure anisotrope de ces couches isolantes à l'aide du masque de résine 30 dont l'ouverture présente encore une largeur L plus grande que celle l̳ de la tranchée à réaliser (figure 10). Ensuite, comme représenté sur la figure 8, on effectue une gravure anisotrope de la région 22a du substrat mise à nu sur une profondeur de quelques milliers Å (2000 Å par exemple), à travers le masque 30. Cette gravure peut par exemple être réalisée avec de l'hexafluorure de soufre (SF₆) ou du tétrachlorure de carbone (CCl₄).

Après cette gravure anisotrope et élimination du masque 30, on réalise, comme représenté sur la figure 9, des espaceurs isolants 44 notamment en oxyde de silicium, sur les flancs gravés des couches isolantes 24, 26 et 28 ainsi que sur les flancs du substrat 22 gravé. Ces espaceurs 44 définissent, comme précédemment, la largeur réelle l̳ de la tranchée à réaliser.

On effectue ensuite, comme précédemment, une gravure anisotrope de la région 22a du substrat afin de réaliser la tranchée 36, comme représentée sur la figure 10, la couche d'oxyde de silicium 28 gravée et les espaceurs 44 servant de masque à cette gravure. Après élimination de ce masque, réalisation des bords isolants 38 et remplissage de la tranchée 36 par du silicium polycristallin 40, on réalise une oxydation thermique de ce silicium polycristallin afin d'obtenir un oxyde de champ 46 localisé. Comme représenté sur la figure 11, cet oxyde de champ 46 se trouve complètement enterré dans le substrat 22.

On peut ensuite éliminer la couche d'oxyde 24 et la couche de nitrure 26.

Dans une autre variante représentée sur les figures 12 et 13, on effectue comme précédemment, l'empilement des couches isolantes 24, 26 et 28, leur gravure anisotrope et l'élimination du masque de résine servant à cette gravure. Ensuite, on réalise des espaceurs isolants 34 comme décrit précédemment dans le cas d'un oxyde de champ localisé partiellement enterré. Après la réalisation de ces espaceurs 34, on effectue, comme représenté sur la figure 12, une légère gravure isotrope de la région 22a du substrat mise à nu, c'est-à-dire une gravure selon les trois directions de l'espace. Cette gravure isotrope du substrat permet d'obtenir un profil incliné 48 du flanc gravé dudit substrat. Elle peut être réalisée par exemple au moyen d'une gravure chimique avec de l'hydroxyde de potassium (KOH) ou au moyen d'une gravure par plasma en pente, avec comme agent d'attaque l'hexafluorure de soufre (SF$_6$) ou du tétrachlorure de carbone (CCl$_4$). Cette gravure isotrope est réalisée en utilisant la couche d'oxyde de silicium 28 gravée et les espaceurs isolants 34 comme masque.

On réalise ensuite comme précédemment, à l'aide de ce même masque, une gravure anisotrope de la région 22a du substrat afin de réaliser, comme représenté sur la figure 13, la tranchée d'isolement 36. Après élimination du masque, réalisation des bords isolants et remplissage de cette tranchée, comme précédemment, par du silicium polycristallin, on réalise une oxydation thermique de ce silicium polycristallin conduisant à l'obtention d'un oxyde de champ localisé complètement enterré dans le substrat.

Comme précédemment, l'autopositionnement d'un oxyde de champ localisé complètement enterré dans le substrat par rapport à une tranchée d'isolement est réalisé grâce à l'emploi des espaceurs isolants 44 ou 34 et à l'emploi d'un masque en résine 30 comportant une ouverture dont la largeur est plus grande que celle de la tranchée d'isolement à réaliser.

Le procédé de l'invention servant à autopositionner ou autoaligner un oxyde de champ localisé par rapport à une tranchée d'isolement permet d'augmenter de façon notable la densité d'intégration des circuits intégrés, notamment du type CMOS ou bipolaire, utilisant un tel procédé pour isoler électriquement entre eux les composants de ces circuits.

## Revendications

1. Procédé d'autopositionnement d'un oxyde de champ localisé (42, 46) par rapport à une tranchée d'isolement (36) dans un substrat en silicium (22), caractérisé en ce qu'il comprend les étapes successives suivantes:

(a) réalisation d'au moins une première couche de matériau isolant (24, 26) sur la surface du substrat (22),

(b) réalisation d'une deuxième couche de matériau isolant (28) sur ladite première couche (24, 26),

(c) réalisation d'une gravure anisotrope des première (24, 26) et deuxième (28) couches de matériau isolant jusqu'à la mise à nu de la région (22a) du substrat dans laquelle sera réalisé la tranchée (36),

(d) réalisation d'espaceurs isolants (34, 44) sur les flancs gravés des première (24, 26) et deuxième (28) couches de matériau isolant,

(e) réalisation d'une gravure anisotrope de ladite région (22a) du substrat afin de réaliser la tranchée (36), la deuxième couche de matériau isolant gravée (28) et les espaceurs (34, 44) servant de masque à cette gravure,

(f) élimination de la deuxième couche de matériau isolant gravée (28) et des espaceurs (34, 44),

(g réalisation de bords isolants (38) dans la tranchée (36),

(h) remplissage de la tranchée (36) par un matériau (40), et

(i) réalisation de l'oxyde de champ localisé (42, 46).

2. Procédé selon la revendication 1, caractérisé en ce que l'on réalise une couche d'oxyde de silicium (24) sur la surface du substrat (22) puis une couche de nitrure de silicium (26) sur ladite couche d'oxyde (24).

3. Procédé selon la revendication 2, caractérisé en ce que l'on réalise la couche d'oxyde de silicium (24) par oxydation thermique du substrat (22)

4. Procédé selon l'une quelconque des revendications 2 et 3, caractérisé en ce que l'on réalise la couche de nitrure de silicium (26) par dépôt.

5. Procédé selon l'une quelconque des revendications 1 à 4, caractérisé en ce que la deuxième couche de matériau isolant (28) est réalisée en oxyde de silicium.

6. Procédé selon l'une quelconque des revendications 1 à 5, caractérisé en ce que l'on réalise la deuxième couche de matériau isolant (28) par dépôt.

7. Procédé selon l'une quelconque des revendications 1 à 6, caractérisé en ce que l'on réalise, entre les étapes (7 et (c), un masque de résine (30) sur la deuxième couche de matériau isolant (28) servant à définir l'emplacement de la tranchée (36).

8. Procédé selon la revendication 7, caractérisé en ce que le masque de résine (30) présente une ouverture (32) dont la largeur (L) est plus grande que celle (l) de la tranchée à réaliser (36).

9. Procédé selon l'une quelconque des revendications 7 et 8, caractérisé en ce que entre les étapes (c) et (d) on élimine le masque de résine (30).

10. Procédé selon l'une quelconque des revendications 1 à 9, caractérisé en ce que l'on réalise les espaceurs isolants (34, 44) en déposant une troisième couche de matériau isolant sur la deuxième couche de matériau isolant gravée (28) puis en gravant ladite troisième couche de façon anisotrope.

11. Procécé selon l'une quelconque des revendications 1 à 10, caractérisé en ce que les espaceurs (34, 44) sont réalisés en oxyde de silicium.

12. Procédé selon l'une quelconque des revendications 1 à 11, caractérisé en ce que l'on réalise les bords isolants (38) de la tranchée (36) par oxydation thermique du substrat gravé (22).

13. Procédé selon l'une quelconque des revendications 1 à 12, caractérisé en ce que l'on réalise le remplissage de la tranchée (36) par un dépôt isotrope.

14. Procédé selon la revendication 13, caractérisé en ce que l'on élimine le matériau de remplissage excédent (40) se trouvant hors de la tranchée (36) de façon à obtenir une surface plane.

15. Procédé selon l'une quelconque des revendications 1 à 14, caractérisé en ce que le matériau de remplissage (40) est du silicium polycristallin.

16. Procédé selon la revendication 15, caractérisé en ce que l'on réalise l'oxyde de champ (42, 46) par oxydation thermique du silicium polycristallin (40).

17. Procédé selon l'une quelconque des revendications 7 à 16, caractérisé en ce que, l'on réalise, entre les étapes (c) et (d), une légère gravure anisotrope de la région (22a) du substrat mise à nu, à travers le masque de résine (30).

18. Procédé selon la revendication 17, caractérisé en ce que l'on réalise des espaceurs (44) sur les flancs gravés des première (24, 26) et deuxième (28) couches de matériau isolant ainsi que sur les flancs gravés de la région (22a) du substrat mise à nu.

19. Procédé selon l'une quelconque des revendications 1 à 16, caractérisé en ce que l'on réalise, entre les étapes (d) et (e), une légère gravure isotrope de la région (22a) du substrat mise à nu, la deuxième couche de matériau isolant gravée (28) et les espaceurs (34) servant de masque à cette gravure.

20. Procédé selon l'une quelconque des revendications 1 à 19, caractérisé en ce que, après l'étape (i), on élimine la première couche de matériau isolant (24, 26).

## PATENTANSPRÜCHE

1. Verfahren zur Selbstausrichtung eines lokalisierten Feldoxids (42, 46) in bezug auf eine Isolierfuge (36) in einem Siliziumsubstrat (22), dadurch gekennzeichnet, dass es die nachstehenden aufeinander folgenden Schritte umfasst:

a) Bildung wenigstens einer ersten Schicht eines Isolierstoffs (24, 26) auf der Oberfläche des Substrats (22),
b) Bildung einer zweiten Schicht eines Isolierstoffs (28) auf der ersten Schicht (24, 26),
c) anisotropes Ätzen der ersten (24, 26) und der zweiten (28) Schicht aus Isolierstoffen bis zur Freilegung des Bereichs (22a) des Substrats, in welchem die Fuge (36) zu bilden ist.

d) Bildung von isolierenden Begrenzungen (34, 44) auf den geätzten Flanken der ersten (24, 26) und der zweiten (28) Isolierstoffschichten,
e) anisotropes Ätzen des genannten Bereichs (22a) des Substrats zur Bildung der Fuge (36), wobei die geätzte zweite Schicht (28) aus Isolierstoff und die Begrenzungen (34, 44) als Maske für das Ätzen dienen,
f) Entfernen der geätzten zweiten Isolierstoffschicht (28) und der Begrenzungen (34, 44),
g) Bildung von isolierenden Rändern (38) in der Fuge (36),
h) Ausfüllen der Fuge (36) mit einem Material (40), und
i) Bildung des lokalisierten Feldoxids (42, 46).

2. Verfahren nach Anspruch 1, dadurch gekennzeichnet, dass man auf der Oberfläche des Substrats (22) eine Siliziumoxidschicht (24) und danach eine Siliziumnitratschicht (26) auf der Siliziumoxidschicht (24) ausbildet.

3. Verfahren nach Anspruch 2, dadurch gekennzeichnet, dass man die Siliziumoxidschicht (24) durch thermische Oxidation des Substrats (22) bildet.

4. Verfahren nach einem der Ansprüche 2 und 3, dadurch gekennzeichnet, dass man die Siliziumnitratschicht (26) durch Deponieren bildet.

5. Verfahren nach einem der Ansprüche 1 bis 4, dadurch gekennzeichnet, dass die zweite Schicht (28) aus Isolierstoff aus Siliziumoxid gebildet wird.

6. Verfahren nach einem der Ansprüche 1 bis 5, dadurch gekennzeichnet, dass man die zweite Isolierstoffschicht (28) durch Deponieren bildet.

7. Verfahren nach einem der Ansprüche 1 bis 6, dadurch gekennzeichnet, dass man zwischen den Schritten b) und c) eine Maske (30) aus einem Harz auf der zweiten Isolierstoffschicht (28) bildet, welche zum Festlegen der örtlichen Anordnung der Fuge (36) dient.

8. Verfahren nach Anspruch 7, dadurch gekennzeichnet, dass die Maske (30) aus dem Harz eine Öffnung (32) aufweist, deren Breite (L) grösser ist als die Breite ( L.) der auszubildenden Fuge (36).

9. Verfahren nach einem der Ansprüche 7 und 8, dadurch gekennzeichnet, dass man die Maske (30) aus dem Harz zwischen den Schritten c) und d) entfernt.

10. Verfahren nach einem der Ansprüche 1 bis 9, dadurch gekennzeichnet, dass man die isolierenden Begrenzungen (34, 44) bildet, indem man eine dritte Isolierstoffschicht auf der geätzten zweiten Isolierstoffschicht (28) deponiert und die dritte Isolierstoffschicht anschliessend anisotrop ätzt.

11. Verfahren nach einem der Ansprüche 1 bis 10, dadurch gekennzeichnet, dass die Begrenzungen (34, 44) aus Siliziumoxid gebildet werden.

12. Verfahren nach einem der Ansprüche 1 bis 11, dadurch gekennzeichnet, dass man die isolierenden Ränder (38) der Fuge (36) durch thermisches Oxidieren des geätzten Substrats (22) bildet.

13. Verfahren nach einem der Ansprüche 1 bis 12, dadurch gekennzeichnet, dass man das Füllen der Fuge (36) durch isotropes Deponieren bewerkstelligt.

14. Verfahren nach Anspruch 13, dadurch gekennzeichnet, dass man ausserhalb der Fuge (36) befindliches, überschüssiges Füllmaterial (40) entfernt, um eine ebene Oberfläche zu erhalten.

15. Verfahren nach einem der Ansprüche 1 bis 14, dadurch gekennzeichnet, dass das Füllmaterial (40) polykristallines Silizium ist.

16. Verfahren nach Anspruch 15, dadurch gekennzeichnet, dass man das Feldoxid (42, 46) durch termisches Oxydieren des polykristallinen Siliziums bildet.

17. Verfahren nach einem der Ansprüche 7 und 16, dadurch gekennzeichnet, dass man den freigelegten Bereich (22a) des Substrats zwischen den Schritten c) und d) einer leichten anisotropen Ätzung durch die Harzmaske (30) hindurch unterwirft.

18. Verfahren nach Anspruch 17, dadurch gekennzeichnet, dass man die Begrenzungen (44) an den geätzten Flanken der ersten (24, 26) und der zweiten (28) Isolierstoffschichten sowie an den geätzten Flanken des freigelegten Bereichs (22a) des Substrats ausbildet.

19. Verfahren nach einem der Ansprüche 1 bis 16, dadurch gekennzeichnet, dass man zwischen den Schritten d) und e) eine leichte isotrope Ätzung des freigelegten Bereichs (22a) des Substrats ausführt, wobei die geätzte zweite Isolierstoffschicht (28) und die Begrenzungen (34) als Maske für das Ätzen dienen.

20. Verfahren nach einem der Ansprüche 1 bis 19, dadurch gekennzeichnet, dass man die erste Isolierstoffschicht (24, 26) nach dem Schritt i) entfernt.

**Claims**

1. Process for the autopositioning of a local field oxide (42, 46) with respect to an insulating trench (36) with a silicon substrate (22) characterized in that it comprises the following successive stages:

(a) forming at least one first insulating material (24, 26) coating on the substrate (22) surface;
b) forming a second insulating material coating (28) on said first coating (24, 26);
(c) anisotropically etching the first (24, 26) and second (28) insulating material coatings until the region (22a) of the substrate in which the trench (36) is to be formed is exposed;
(d) formation of insulating spacers (34, 44) on the etched flanks of the first (24, 26) and second (28) insulating material coatings;
(e) anisotropically etching said region (22a) of the substrate in order to produce the trench (36), the second etched insulating material coating (28) and the spacers (34, 44) acting as a mask for said etching;
(f) elimination of the second etched insulating material coating (28) and the spacers (34, 44);

(g) formation of insulating edges (38) in the trench (36);
(h) filling the trench (36) with a filling material (40), and
(i) producing the local field oxide (42, 46).

2. Process according to claim 1, characterized in that a silicon oxide coating (24) is formed on the substrate (22) surface, followed by a silicon nitride coating (26) on the oxide coating (24).

3. Process according to claim 2, characterized in that the silicon oxide coating (24) is formed by thermal oxidation of the substrate (22).

4. Process according to either of the claims 2 and 3, characterized in that the silicon nitride coating (26) is formed by deposition.

5. Process according to any one of the claims 1 to 4, characterized in that the second insulating material coating (28) is formed from silicon oxide.

6. Process according to any one of the claims 1 to 5, characterized in that the second insulating material coating (28) is formed by deposition.

7. Process according to any one of the claims 1 to 6, characterized in that between stages (b) and (c), is formed a resin mask (30) on the second insulating material coating (28) and which is used for defining the location of the trench (36).

8. Process according to claim 7, characterized in that the resin mask (30) has an opening (32) having a greater width (L) than that (l) of the trench to be formed (36).

9. Process according to either of the claims 7 and 8, characterized in that the resin mask (30) is eliminated between stages (c) and (d).

10. Process according to any one of the claims 1 to 9, characterized in that insulating spacers (34, 44) are formed by depositing a third insulating coating on the second etched insulating material coating (28) and then by anisotropically etching said third coating.

11. Process according to any of the claims 1 to 10, characterized in that the spacers (34, 44) are made from silicon oxide.

12. Process according to any one of the claims 1 to 11, characterized in that the insulating edges (38) of the trench (36) are formed by thermal oxidation of the etched substrate (22).

13. Process according to any on of the claims 1 to 12, characterized in that the trench (36) is filled by isotropic deposition.

14. Process according to claim 13, characterized in that the excess filling material (40) inside the trench (36) is eliminated, so as to obtain a planar surface.

15. Process according to any one of the claims 1 to 14, characterized in that the filling material (40) is polycrystalline silicon.

16. Process according to claim 15, characterized in that the field oxide (42, 46) is produced by thermal oxidation of the polycrystalline silicon (40).

17. Process according to any one of the claims 7 to 16, characterized in that between stages (c) and (d), there is a slight an isotropic etching of the exposed substrate region (22a) through the resin mask (30).

18. Process according to claim 17, characterized in that the spacers (44) are formed on the etched flanks of the first (24, 26) and second (28) insulating material coatings, as well as on the etched flanks of the exposed substrate region (22a).

19. Process according to any one of the claims 1 to 16, characterized in that between stages (d) and (e), there is a slight isotropic etching of the exposed substrate region (22a), the second etched insulating material coating (28) and the spacers (34) used as a mask for said etching.

20. Process according to any one of the claims 1 to 19, characterized in that following stage (i), the first insulating material coating (24, 26) is eliminated.

FIG.1

FIG.2

FIG.3

FIG.4

FIG.5

FIG.6

FIG.7

FIG.8

FIG. 9

FIG.10

FIG.11

FIG.12

FIG.13